# EUROPEAN PATENT SPECIFICATION

(11) **EP 0 267 785 B1**
(45) Date of publication and mention of the grant of the patent: **15.06.1994**
(21) Application number: 87309964.2
(22) Date of filing: 11.11.1987
(51) Int. Cl.: H04N 5/92, H03G 5/00

(54) **Digital non-linear pre-emphasis/de-emphasis apparatus**
Vorrichtung zur digitalen nichtlinearen Vorverzerrung und Nachentzerrung
Dispositif de préaccentuation/désaccentuation non-linéaire numérique

(30) Priority: 14.11.1986 JP 272498/86; 29.05.1987 JP 135131/87
(43) Date of publication of application: 18.05.1988
(73) Proprietor: MATSUSHITA ELECTRIC INDUSTRIAL CO., LTD., Kadoma-shi, Osaka-fu, 571 (JP)
(72) Inventor: Ohta, Haruo, Yawata-shi Kyoto-fu, 614 (JP)
(74) Representative: Crawford, Andrew Birkby

(56) References cited:
- EP-A- 0 175 275
- DE-A- 3 206 047
- DE-A- 3 439 126
- IEEE TRANSACTIONS ON CONSUMER ELECTRONICS, vol. CE-32, no. 3, August 1986, pages 372-378, IEEE, New York, US; S. KATO et al.: "Digital video signal processing in home VTRs"

## Description

The present invention relates to a digital-signal non-linear pre-emphasis/de-emphasis apparatus used for eliminating noise components from video signals in a video signal processing system such as a video tape recorder.

Recently, a variety of arts have been proposed for digitally processing video signals while either recording or reproducing video signals in the conventional consumer-standard video tape recorders designed for recording analogue video signals on a magnetic tape.

More particularly, in recording mode, an input analog video signal is converted to a digital signal to be subjected to various digital signal processings required for recording, and reconverted to an analog signal before eventually being recorded on a magnetic tape. Conversely, in reproduction mode, an analog video signal reproduced from a magnetic tape is converted to a digital signal to be subjected to various digital signal processings required for reproduction, and reconverted to an analog video signal before eventually being outputted to the TV monitor. Actually, by digitally processing video signals instead of the conventional analog video signal processing and by introducing large-scale digital ICs, drastical reduction of components required for a video tape recorder, and significant improvement of performance and stability of a video tape recorder can be realized. For example, refer to a technical report "Digital Signal Processing in Video Tape Recorders" written by S. Mehrgardt, IEEE Trans. on Consumer Electronics, Vol. CE-31, No. 3, pages 374 through 377, issued on August, 1985.

In order to effectively reduce noise from video signals during recording or reproduction normally, any of those conventional consumer-use video tape recorders incorporates non-linear pre-emphasis and de-emphasis circuits.

Concretely, in the recording mode, the non-linear pre-emphasis circuit emphasizes high-frequency components of a video signal in such a way that the emphasis amount becomes larger as the signal amplitude becomes smaller, thereby allowing the needed emphasis operation without expanding the dynamic range of the video signal. In the reproduction mode, the non-linear de-emphasis circuit executes de-emphasis process in the reverse way to that of the emphasis process. These processes significantly suppress noise components having small amounts of amplitude and also effectively suppress waveform distortion of signal components having large amounts of amplitude. Since the pre-emphasis and de-emphasis characteristics are reverse to each other, basically, signal components remain free from degradation.

The non-linear pre-emphasis circuit mentioned above has already been realized by effectively utilizing non-linear characteristic of diodes. Likewise, the non-linear de-emphasis circuit having reverse characteristic that of the non-linear pre-emphasis circuit has also been realized by inserting a non-linear pre-emphasis circuit into the negative feedback path of an operational amplifier.

However, when digitally processing video signals during the recording and reproduction modes, there arises a problem regarding how to realize a digital non-linear pre- emphasis circuit and a digital non-linear de-emphasis circuit which have reverse characteristics to each other.

EP-A-0175275 discloses a digital non-linear pre-emphasis/de-emphasis apparatus having a non-linear signal processing circuit which comprises a differential circuit, a non-linear circuit for non-linearly comprises an amplitude of a signal, a delay circuit for delaying an output signal of the non-linear circuit, an adder for adding output signals of the differential circuit and delay circuit and feeding the added signal to the non-linear circuit, and a multiplier for multiplying the output signal of the non-linear circuit by a predetermined factor. In this apparatus, the non-linear characteristic of the whole apparatus is determined only by the non-linear circuit so that the freedom of setting the non-linear characteristic is small. Further, EP-A-0175275 shows that non-linear pre-emphasis and its inverse non-linear de-emphasis can be constructed. However, since it is generally known that analysis by Laplace transform or Z-transform cannot be applied to a non-linear circuit the non-linear circuit composed of non-linear diodes is replaced by a linear circuit composed of a potentiometer so that analysis by Laplace transform or z-transform can be applied. This allows an approximately correct analysis to be undertaken. Accordingly, it would not be expected to obtain a desirable non-linear pre-emphasis/de-emphasis apparatus by the art disclosed in EP-A-0175275.

The primary object of the present invention is to provide a novel digital non-linear pre-emphasis apparatus which executes non-linear pre-emphasis process by implementing digital signal processing.

Another object of the invention is to provide a novel digital non-linear pre-emphasis apparatus which is capable of independently setting a specific frequency band to be emphasized and the emphasis amount in order that these can vary themselves in accordance with signal amplitude.

Still another object of the invention is to provide a novel digital non-linear de-emphasis apparatus which executes non-linear de-emphasis process accurately reverse to the non-linear pre-emphasis process by implementing digital signal processing.

A further object of the invention is to provide a novel digital non-linear pre-emphasis/de-emphasis apparatus which is capable of selectively executing both the non-linear pre-emphasis process and the non-linear de-emphasis process which are reverse in characteristic to each other by implementing digital signal processing.

To securely achieve those objects mentioned above, a digital non-linear pre-emphasis/de-emphasis apparatus according to the present invention executes a process satisfying the following condition:

${\text{y}}_{\text{n}} {\text{= b}}_{\text{n}} {\text{· u}}_{\text{n}} {\text{+ x}}_{\text{n}}$
${\text{u}}_{\text{n}} {\text{= x}}_{\text{n}} {\text{- x}}_{\text{n-k}} {\text{+ a}}_{\text{n-k}} {\text{· u}}_{\text{n-k}}$

A digital non-linear pre-emphasis/de-emphasis apparatus, characterizing by satisfying the following conditions:

${\text{y}}_{\text{n}} {\text{= b}}_{\text{n}} {\text{u}}_{\text{n}} {\text{+ X}}_{\text{n}}$ ; and
${\text{u}}_{\text{n}} {\text{= x}}_{\text{n}} {\text{- x}}_{\text{n}} {\text{-}}_{\text{k}} {\text{+ a}}_{\text{n-k}} {\text{.u}}_{\text{n-k}}$

where xₙ denotes an input signal; yₙ denotes an output signal; uₙ denotes a parameter; each of aₙ and bₙ is a function of uₙ; k is a positive integer; the subscript "n" refers to an n-th sample of a sampled digital signal; and the subscript "n-k" refers to a sample k-sample periods before the n-th sample.

An apparatus executing such process comprises: a high-pass filter means for obtain a high frequency component signal uₙ of an input signal xₙ; a first non-linear processing means for multiplying the signal uₙ by a coefficient aₙ which is a function of uₙ to obtain a feedback signal aₙ·uₙ which is fed back to the high-pass filter means to vary a frequency band of the high-pass filter means; a second non-linear processing means for multiplying the signal uₙ by a coefficient bₙ which is a function of uₙ to obtain a signal bₙ·uₙ; and an operation means for mixing the input signal xₙ and the output signal bₙ·uₙ of the second non-linear processing means to obtain an output signal ${\text{y}}_{\text{n}} {\text{= b}}_{\text{n}} {\text{·u}}_{\text{n}} {\text{+ x}}_{\text{n}}$ . The output signal uₙ of the high-pass filter means is ${\text{u}}_{\text{n}} {\text{+ x}}_{\text{n}} {\text{- x}}_{\text{n-k}} {\text{+ a}}_{\text{n-k}} {\text{·u}}_{\text{n-k}} \text{= (input signal) - (delayed input signal) + delayed feedback signal)}$ .

By properly selecting the function of each of the first and second non-linear processing means, the apparatus having this configuration can operate either a non-linear pre-emphasis apparatus or a non-linear de-emphasis apparatus.

When the coefficients of the first and second non-linear processing means are respectively set to be a(u) and b(u) with respect to an input signal thereto u to obtain a non-linear pre-emphasis apparatus, a n0n-linear de-emphasis apparatus having a non-linear de-emphasis characteristic reverse to a non-linear pre-emphasis characteristic of the non-linear pre-emphasis apparatus can be realized by setting coefficients A(U) and B(U) of the respective first and second non-linear processing means with respect to an input signal there to U so as to satisfy the following conditions: 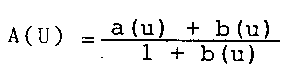
$\text{(1 + b(u))·u}$

Those object mentioned above and further scope of applicability of the present invention will become more apparent from the detailed description given hereinbelow.

The present invention will be better understood from the detailed description given hereinbelow in reference to the appended drawings which are given by way of illustration only and are not limitative of the invention, wherein:
FIG. 1 is a simplified block diagram showing a digital non-linear pre-emphasis apparatus as the first preferred embodiment of the invention;
FIG. 2 is a chart showing a frequency characteristic of an output signal of addition circuit 4 shown in FIG. 1 viewing from input terminal 1;
FIG. 3 is a chart showing a frequency characteristic of the first preferred embodiment;
FIG. 4 is a simplified block diagram showing a digital non-linear de-emphasis apparatus as the second preferred embodiment of the invention;
FIG. 5 is a simplified block diagram showing a digital non-linear pre-emphasis apparatus as the third preferred embodiment of the invention;
FIG. 6 is a simplified block diagram showing a digital non-linear de-emphasis apparatus as the fourth preferred embodiment of the invention;
FIG. 7 is a simplified block diagram showing a digital non-linear pre-emphasis/de-emphasis apparatus as the fifth preferred embodiment of the invention; and
FIG. 8 is a simplified block diagram showing a digital non-linear pre-emphasis/de-emphasis apparatus as the sixth preferred embodiment of the invention.

Referring now more particularly to the accompanying drawings, some preferred embodiments of the apparatus according to the invention are described below on condition that all the input video signals are preliminarily sampled and converted to digital signals before being inputted to the apparatus.

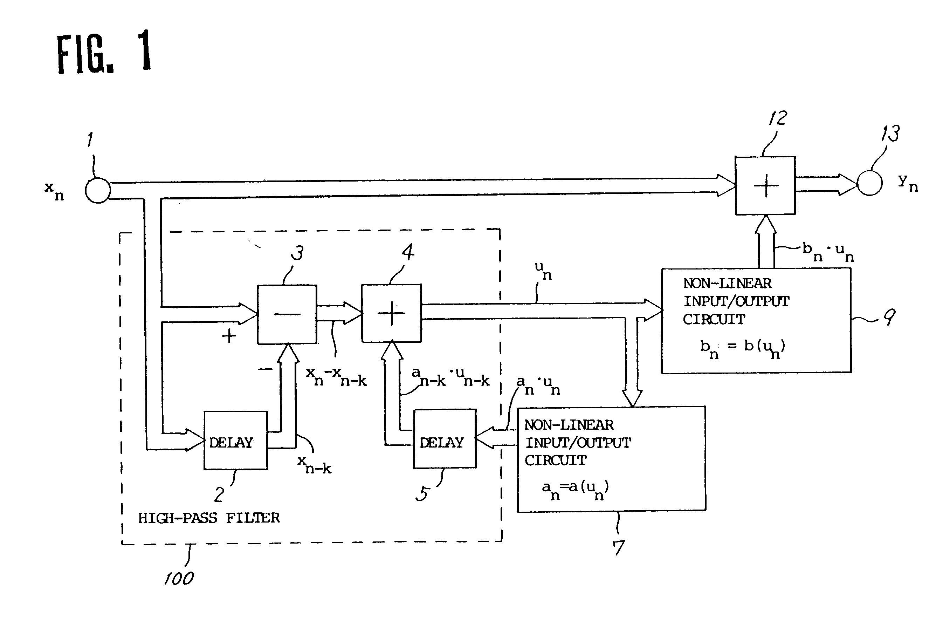

FIG. 1 is a simplified block diagram of the first preferred embodiment of the invention, which is a digital non-linear pre-emphasis/apparatus. The apparatus first receives a preliminarily sampled and digitized video signal at an input terminal 1. Then, a delay circuit 2 causes the input signal to delay itself by a specific time corresponding to k sampling periods (where k denotes a positive integer). The delayed signal is a subtracted from the input signal by a subtraction circuit 3. The output signal of the subtraction circuit 3 is applied to one input terminal of an addition circuit 4. Then, the output signal of the addition circuit 4 is delivered via a non-linear input/output circuit 7 to a delay circuit 5 where it is delayed by the specific time corresponding to be sampling periods, and fed back to the other input terminal of the addition circuit 4. The delay circuit 2, subtraction circuit 3 and addition circuit 4 with a feedback loop constitute a high-pass filter 100. On the other hand, the output signal of the addition circuit 4 is delivered also via a non-linear input/output circuit 9 to an addition circuit 12 where it is added to the input video signal from the input terminal 1 to obtain an output video signal outputted from an output terminal 13.

Each of the non-linear input/output circuits 7 and 9 generates specific output values which are multiplications of its input signal by specific coefficients non-linearly determined by amplitudes of the input signal. Such non-linear input/output circuit can be comprised by a memory which uses the input signal data as address data and has stored therein the specific output values corresponding to addresses specified by the address data.

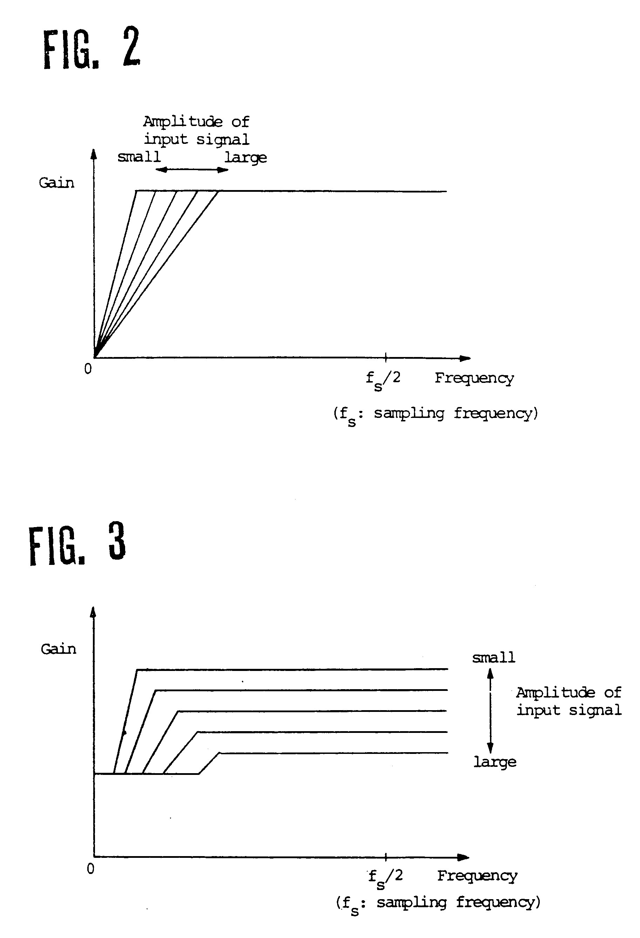

By virtue of the constitution of non-linear input/output circuits 7 and 9 mentioned above, the output signal of the addition circuit 4 with respect to the input video signal shows a specific frequency characteristic as passed through a high-pass filter having such a frequency characteristic that the frequency passing band varies in accordance with the input/output ratio of the non-linear input/output circuit 7, i.e., the coefficients non-linearly determined in accordance with the amplitude of the signal inputted to the non-linear input/output circuit 7. For example, when the input-output characteristic of the non-linear input/output circuit 7 is set such that the smaller amplitude of input signals are multiplied by larger positive coefficients, the high-pass filter characteristic becomes such that the frequency passing band becomes wider as the amplitude of the input signal of the non-linear input/output circuit 7 becomes smaller, as schematically shown in FIG. 2.

Further, when the non-linear input/output circuit 9 is set to have such an input-output characteristic that the smaller amplitude of input signals are multiplied by larger positive coefficients, high frequency components of the smaller amplitude of signals in the input video signal are emphasized in larger amounts in the output video signal at the output terminal 13, as shown by a schematic frequency characteristic in FIG. 3. Thus, a non-linear pre-emphasis characteristic is materialized.

As mentioned above, the first preferred embodiment securely materializes a non-linear pre-emphasis process by digitally processing video signals. Since the apparatus embodied by the invention is totally comprised of digital circuits, compared to analogue signal processing system, the apparatus according to the invention can drastically save the number of components and stabilize video signal processing operations by allowing the apparatus to be integrated on a large-scale IC. The apparatus reflecting the first preferred embodiment independently and optionally sets non-linear input-output characteristics of the non-linear input/output circuit 7 which determines the frequency band to be emphasized and the non-linear input/output circuit 9 which determines the amount of emphasis, respectively.

Here, we consider to describe the operation of the first preferred embodiment of the apparatus according to the present invention by mathematical expressions. Since the apparatus executes non-linear operations, attention should be paid that the operation of the apparatus cannot be expressed in the form of z-transform which is normally used for linear digital filters.

On supposition that an input signal at the input terminal 1 is xₙ at a time n, an output signal at the output terminal 13 is yₙ, an output signal of the addition circuit 4 is uₙ, an output signal of the non-linear input/output circuit 7with respect to the output signal uₙ is aₙ·uₙ, an output signal of the non-linear input/output circuit 9 is bₙ·uₙ, i.e., coefficients realized by the non-linear input/output circuits 7 and 9 are respectively aₙ and bₙ, and the delay time by each of the delay circuits 2 and 5 is substantially k sampling periods, the following equations can be established:

${\text{y}}_{\text{n}} {\text{= x}}_{\text{n}} {\text{+ b}}_{\text{n}} {\text{u}}_{\text{n}} \text{(1)}$

${\text{u}}_{\text{n}} {\text{= x}}_{\text{n}} {\text{- x}}_{\text{n-k}} {\text{+ a}}_{\text{n-k}} {\text{u}}_{\text{n-k}} \text{(2)}$

Based on these equations (1) and (2), the following equation can be established:

${\text{y}}_{\text{n}} {\text{= (1 + b}}_{\text{n}} {\text{) x}}_{\text{n}} {\text{- b}}_{\text{n}} {\text{(a}}_{\text{n-k}} {\text{/b}}_{\text{n-k}} {\text{+ 1) x}}_{\text{n-k}} {\text{+ (a}}_{\text{n-k}} {\text{b}}_{\text{n}} {\text{/b}}_{\text{n-k}} {\text{) y}}_{\text{n-k}} \text{(3)}$

Since aₙ and bₙ are respectively the functions of uₙ, the following equations (4) and (5) can be established:

${\text{a}}_{\text{n}} {\text{= a (u}}_{\text{n}} \text{) (4)}$

${\text{b}}_{\text{n}} {\text{= b (u}}_{\text{n}} \text{) (5)}$

Although the first embodiment has been described as the non-linear pre-emphasis apparatus, a non-linear de-emphasis apparatus can be realized in the same configuration by merely changing the functions a(uₙ) and b(uₙ) of the non-linear input/output circuit as will be described next.

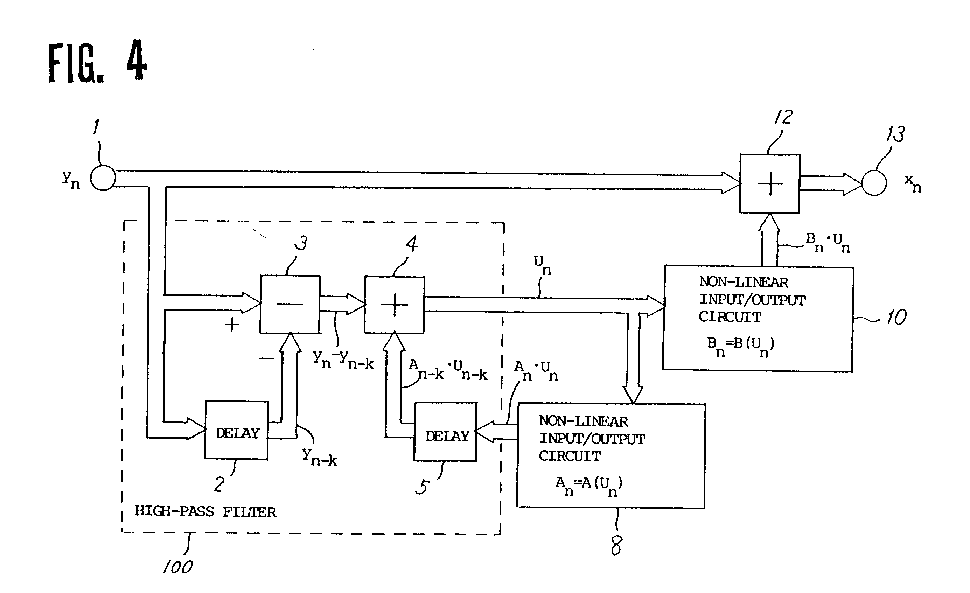

Next, referring to FIG. 4, the second preferred embodiment of the present invention is described below, in which the second preferred embodiment materializes a non-linear de-emphasis characteristic entirely being reverse to the above non-linear pre-emphasis characteristic.

FIG. 4 is a simplified block diagram of the second preferred embodiment, which features its difference from the first preferred embodiment shown in FIG. 1 in the introduction of non-linear input/output circuits 8 and 10 in place of non-linear input/output circuits 7 and 9. The circuits 8 and 10 have different input/output characteristics from those of the circuits 7 and 9.

In the embodiment of FIG. 4, on supposition that a signal received at the input terminal 1 is yₙ at a time n, an output signal at the output terminal 13 is xₙ, an output signal of the addition circuit 4 is Uₙ, an output signal of the non-linear input/output circuit 8 with respect to Uₙ is Aₙ·Uₙ, an output signal of the non-linear input/output circuit 10 with respect to Uₙ is Bₙ·Uₙ, i.e., coefficients realized by the non-linear input/output circuits 8 and 10 are respectively Aₙ and Bₙ, the following equations and can be established:

${\text{x}}_{\text{n}} {\text{= y}}_{\text{n}} {\text{+ B}}_{\text{n}} {\text{U}}_{\text{n}} \text{(6)}$

${\text{U}}_{\text{n}} {\text{= y}}_{\text{n}} {\text{- y}}_{\text{n-k}} {\text{+ A}}_{\text{n-k}} {\text{U}}_{\text{n-k}} \text{(7)}$

Based on these equations (6) and (7), the following equation can be established:

${\text{x}}_{\text{n}} {\text{= (1 + B}}_{\text{n}} {\text{) y}}_{\text{n}} {\text{- B}}_{\text{n}} {\text{(A}}_{\text{n-k}} {\text{/B}}_{\text{n-k}} {\text{+ 1) y}}_{\text{n-k}} {\text{+ (A}}_{\text{n-k}} {\text{B}}_{\text{n}} {\text{/B}}_{\text{n-k}} {\text{) x}}_{\text{n-k}} \text{(8)}$

Since Aₙ and Bₙ are respectively the functions of Uₙ, the following equations can be established.

${\text{A}}_{\text{n}} {\text{= A (U}}_{\text{n}} \text{) (9)}$

${\text{B}}_{\text{n}} {\text{= B (U}}_{\text{n}} \text{) (10)}$

Here, in order to securely obtain a non-linear de-emphasis characteristic entirely being reverse to the previously described non-linear pre-emphasis characteristic, xₙ should be the output occurring when yₙ shown in equation (3) is inputted. Based on equation (3), the following equation can be established 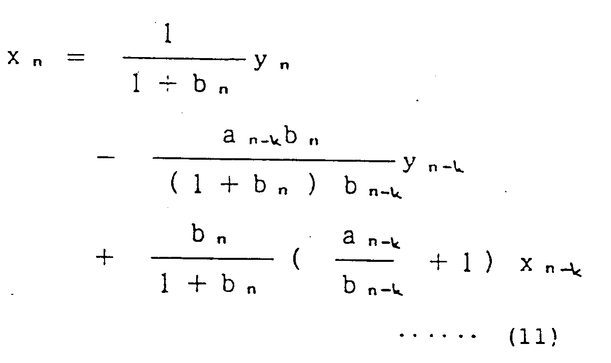
Assuming that coefficients of yₙ, yₙ₋ₖ and xₙ₋ₖ shown in equations (8) and (11) are equal to each other, it is understood that specific conditions expressed by the following equations (12) and (13) are required.

${\text{A}}_{\text{n}} {\text{= (a}}_{\text{n}} {\text{+ b}}_{\text{n}} {\text{) / (1 + b}}_{\text{n}} \text{) (12)}$

${\text{B}}_{\text{n}} {\text{= -b}}_{\text{n}} {\text{/ (1 + b}}_{\text{n}} \text{) (13)}$

Like equations (9) and (10), in order to make Aₙ and Bₙ functions of uₙ while allowing equations (12) and (13) to be established it is necessary to the relationship between Uₙ shown in equation (7) and aₙ and bₙ shown in equations (4) and (5). Since aₙ and bₙ are functions of uₙ, the relationship between Uₙ and Aₙ, Bₙ can be understood by knowing the relationship between uₙ shown in equation (2) and Uₙ shown in equation (7). The relationship between uₙ and Uₙ can be clarified by referring to equations (1), (6) and (13), as shown below.

${\text{U}}_{\text{n}} {\text{= (1 + b}}_{\text{n}} {\text{)u}}_{\text{n}} \text{(14)}$

In summary, when a non-linear pre-emphasis process is executed by the embodiment shown in FIG. 1 in the condition that the input signal of the non-linear input/output circuits 7 and 9 is expressed by u (n is deleted)and the output signals of the non-linear input/output circuits 7 and 8 are respectively expressed by a(u)·u and b(u)·u, the embodiment shown in FIG. 4 can execute non-linear de-emphasis process reverse to the non-linear pre-emphasis process by setting the input-output characteristics of the non-linear input-output circuits 8 and 10 which receive an input signal U and respectively output signals A(U)·U and B(U)·U so as to satisfy the following equations using u as a parameter: 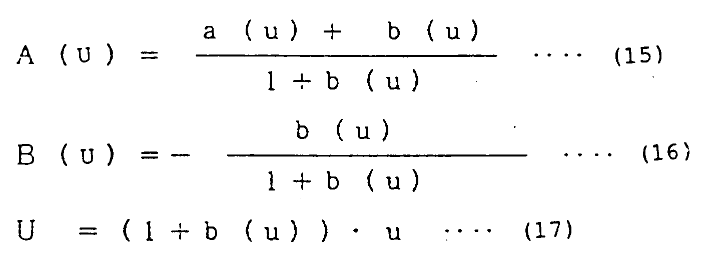
$\text{U = (1 + b (u)) · u (17)}$

Each of the non-linear input/output circuits 8 and 10 can be easily realized by a memory using the input signal data as address data and stores predetermined output values corresponding to respective addresses specified by the input signal data, fully satisfying requirements expressed by equations (15) through (17).

As mentioned above, the second preferred embodiment of the apparatus according to the invention executes non-linear de-emphasis operation for generating specific characteristic entirely being reverse to that of non-linear pre-emphasis process. Since the apparatus is totally comprised of digital circuits realizable on a large-scale IC, compared to analogue processing system, drastical saving of the number of components and secure stability of operation can be realized.

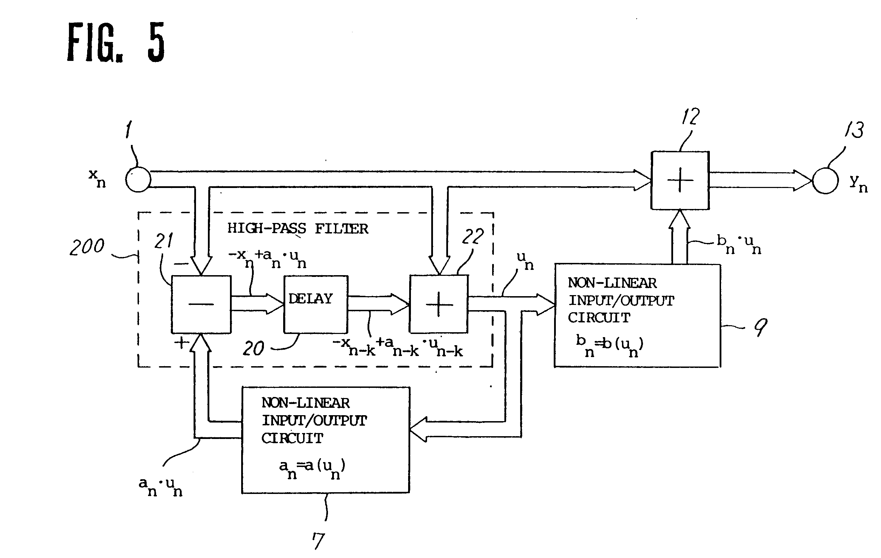

Next, the third preferred embodiment of the present invention is described below. FIG. 5 is a simplified block diagram of the third preferred embodiment which is a non-linear pre-emphasis apparatus. The circuit elements identical to those which are shown in the first preferred embodiment shown in FIG. 1 are respectively denoted by identical reference numerals. The non-linear pre-emphasis apparatus shown in FIG. 5 first receives a sampled digital video signal from the input terminal 1. A subtraction circuit 21 then subtracts the input video signal from a signal which is fed back from non-linear input/output circuit 7. The output signal of the subtraction circuit 21 is delayed by a delay circuit 20 by a specific time corresponding to k sampling periods. The delayed signal is added to the input video signal from the input terminal 1 by an addition circuit 22. The output signal of the addition circuit 22 is delivered to the non-linear input output circuit 7. The subtraction circuit 21, delay circuit 20 and addition circuit 22 with a feedback loop constitute a high-pass filter 200 having the same function as that of the previously described high-pass filter 100. On the other hand, the output signal of the addition circuit 22 is delivered also via the non-linear input/output circuit 9 to the addition circuit 12 where it is added to the input video signal from the input terminal 1 to obtain an output video signal outputted from the output terminal 13.

Now, as was done for the preceding preferred embodiments, functional operation of the non-linear pre-emphasis apparatus of the third preferred embodiment shown in FIG. 5 is expressed by mathematical expression below. Supposing that, at a time n, an input video signal at the input terminal 1 is xₙ, an output video signal at the output terminal 13 is yₙ, an output signal of the addition circuit 22 is uₙ, and coefficients by the non-linear input/output circuits 7 and 9 with respect to un are respectively aₙ and bₙ, the operation of the apparatus can be expressed by the following equations:

${\text{y}}_{\text{n}} {\text{= x}}_{\text{n}} {\text{+ b}}_{\text{n}} {\text{u}}_{\text{n}} \text{(1)}$

${\text{u}}_{\text{n}} {\text{= x}}_{\text{n}} {\text{- x}}_{\text{n-k}} {\text{+ a}}_{\text{n-k}} {\text{u}}_{\text{n-k}} \text{(2)}$

Based on these equations (1) and (2), the following equation can be established:

${\text{y}}_{\text{n}} {\text{= (1 + b}}_{\text{n}} {\text{) x}}_{\text{n}} {\text{- b}}_{\text{n}} {\text{(a}}_{\text{n-k}} {\text{/ b}}_{\text{n-k}} {\text{+ 1) x}}_{\text{n-k}} {\text{+ (a}}_{\text{n-k}} {\text{b}}_{\text{n}} {\text{/ b}}_{\text{n-k}} {\text{) y}}_{\text{n-k}} \text{(3)}$

This clearly indicates that the apparatus of the third preferred embodiment executes the operation exactly identical to that performed by the apparatus of the first preferred embodiment shown in FIG. 1. In other words, the third preferred embodiment securely executes a non-linear pre-emphasis process by digitally processing video signals. Since the apparatus of the third preferred embodiment is totally comprised of digital circuits which can be integrated on a large-scale IC, compared to analogue processing system, drastical saving of the number of components and secure stability of operation can be realized.

Furthermore, since the apparatus of the third preferred embodiment delays the mixed signal of the input video signal and the fed-back signal from the non-linear input/output circuit 7, the apparatus can realize the same non-linear pre-emphasis characteristic as that of the first embodiment by using only one delay circuit. This feature is effective particularly when executing emphasis with respect to the vertical direction or movement direction of a video signal, in which the video signal must be delayed by one horizontal scanning period or one frame period using a large scale delay circuit.

A non-linear de-emphasis apparatus can be realized in the configuration of the third embodiment by changing the functions a(uₙ) and b(uₙ) of the non-linear input/output circuits as will be described next.

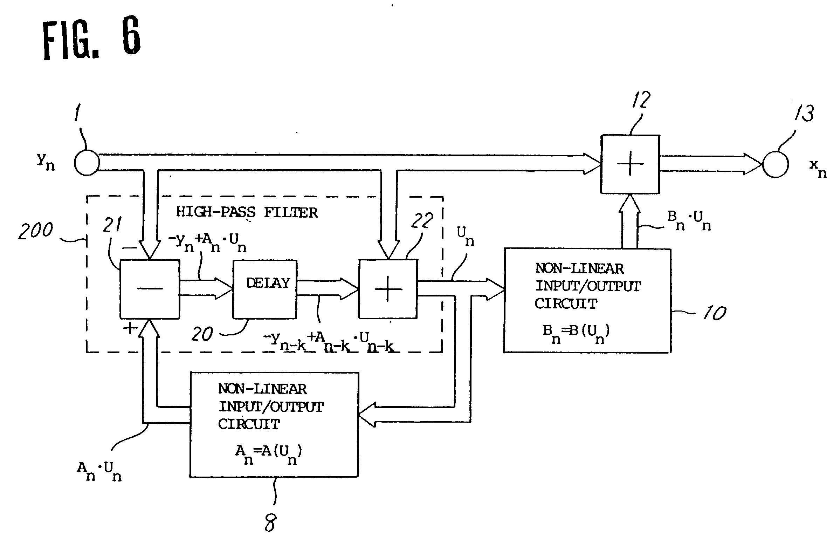

Next, the fourth preferred embodiment of the present invention is described below. FIG. 6 is a simplified block diagram of the fourth preferred embodiment which is a non-linear de-emphasis apparatus. This apparatus is provided with the non-linear input-output circuits 8 and 10 as used in the second embodiment in FIG. 4 in place of the non-linear input/output circuits 7 and 9 in the apparatus of the third preferred embodiment shown in FIG 5.

Supposing that output signals of the non-linear input/output circuits 7 and 9 shown in FIG. 5 are respectively a(u)·u and b(u)·u with respect to an input signal thereto u, and output signals of the non-linear input/output circuit 8 and 10 shown in FIG. 6 are respectively A(U)·U and B(U)·U with respect to an input signal thereto U, the coefficients of the non-linear input/output circuits 8 and 10,A(U) and B(U), are set to satisfy equations (15) through (17) shown in the preceding description. Needless to say that the fourth preferred embodiment executes the same non-linear de-emphasis process as that done by the second preferred embodiment shown in FIG. 4

Next, the fifth and sixth preferred embodiments of the present invention are described below, in which both of these apparatuses correctly switch operations between non-linear pre-emphasis and non-linear de-emphasis processes.

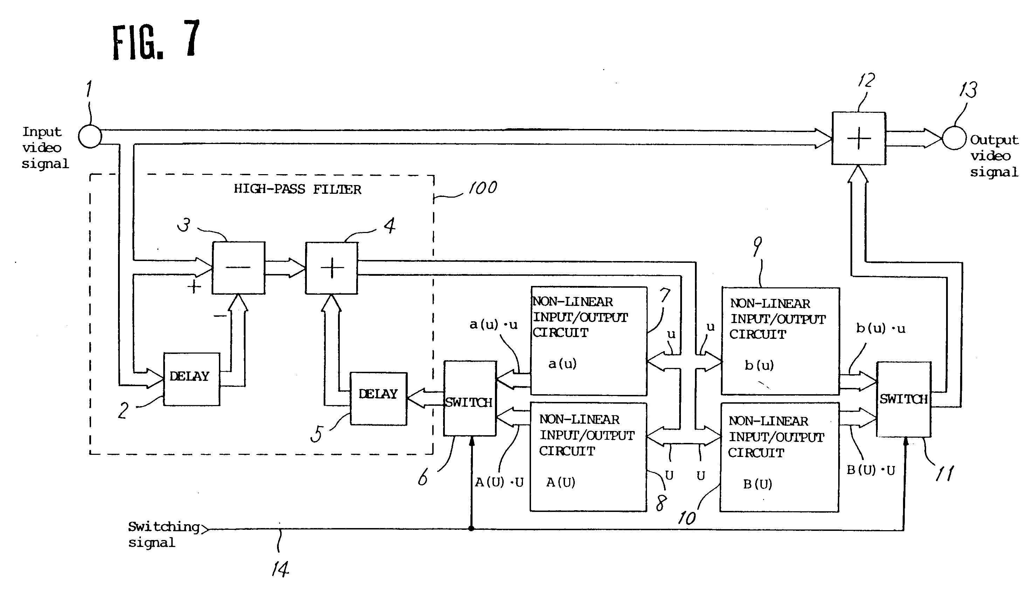

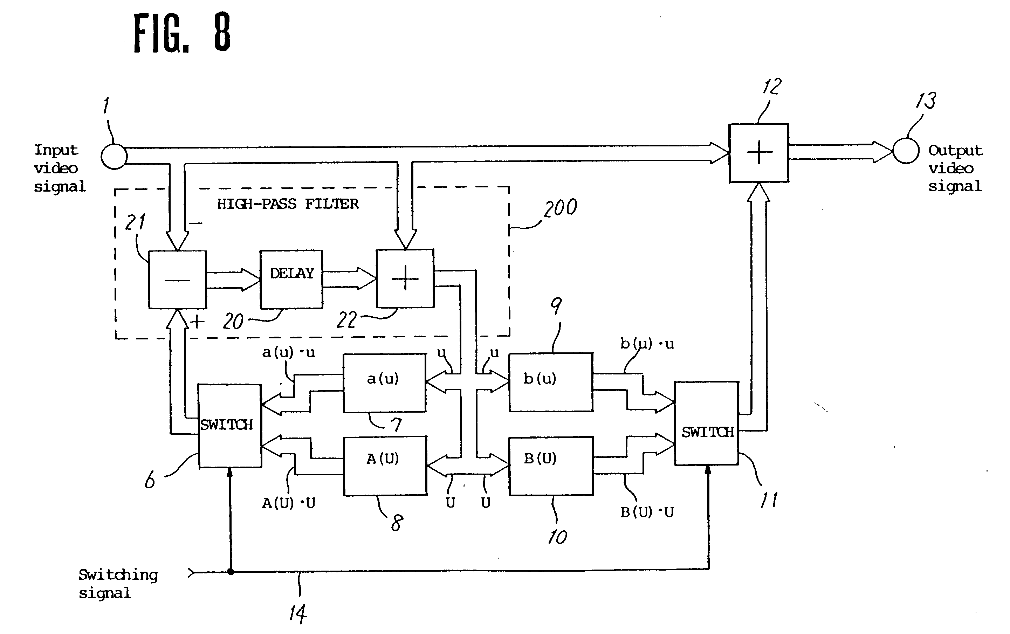

FIGS. 7 and 8 are respectively simplified block diagrams of the fifth and sixth preferred embodiments. Of these, the fifth preferred embodiment shown in FIG. 7 is an improved version from the first preferred embodiment shown in FIG. 1, whereas the sixth preferred embodiment shown in FIG. 8 is an improved version from the third preferred embodiment shown in FIG. 5, in which each of these improved apparatuses selectively switches operations between non-linear pre-emphasis and non-linear de-emphasis processes as required. The fifth and sixth preferred embodiments of the apparatuses are respectively provided with additional non-linear input/output circuits 8 and 9 and also switches 6 and 11 which are controlled by a switching signal 14.

When the apparatus in FIG. 7 or 8 is used in a video signal recording/reproducing apparatus such as a video tape recorder, a recording/reproduction switching signal is used as the switching signal 14 so that the switches 6 and 11 respectively select the non-linear input/output circuits 7 and 9 in the recording mode and respectively select the non-linear input/output circuits 8 and 10 in the reproduction mode.

The non-linear input/output circuits 7 and 9 are respectively provided with the above-described specific input-output characteristics needed for implementing the non-linear pre-emphasis process, whereas the non-linear input/output circuits 8 and 10 are respectively provided with the above-described specific input-output characteristics needed for implementing the non-linear de-emphasis process. That is, supposing that the input signal to and the output signal from the non-linear input/output circuits 7 and 9 are respectively u, a(u)·u and b(u)·u, and the input signal to and the output signal from the non-linear input/output circuits 8 and 10, are respectively U, A(U)·U and B(U)·U, the coefficients of the non-linear input/output circuits 9 and 10, A(U) and B(U), fully satisfy equations (15) through (17).

Consequently, the fifth and sixth preferred embodiments can securely execute both the non-linear pre-emphasis process and the non-linear de-emphasis process reverse to the non-linear pre-emphasis process in a small-scale circuit constitution.

Although some of the preferred embodiments have been described, it should be understood that the spirit and scope of the present invention are not confined to those which have been described above. The non-linear pre-emphasis and de-emphasis apparatus according to the present invention can be realized in a variety of constitutions by fully satisfying those equations shown below.

${\text{y}}_{\text{n}} {\text{= b}}_{\text{n}} {\text{· u}}_{\text{n}} {\text{+ x}}_{\text{n}}$
${\text{u}}_{\text{n}} {\text{= x}}_{\text{n}} {\text{- x}}_{\text{n-k}} {\text{+ a}}_{\text{n-k}} {\text{· u}}_{\text{n-k}}$

where: xₙ denotes an input signal at a time n; yₙ an output signal at a time n; uₙ a parameter; aₙ and bₙ functions of uₙ; and k, a positive integer.

## Claims

1. A digital non-linear pre-emphasis/de-emphasis apparatus, characterized by satisfying the following conditions:
${\text{y}}_{\text{n}} {\text{= b}}_{\text{n}} {\text{u}}_{\text{n}} {\text{+ X}}_{\text{n}}$ ; and
${\text{u}}_{\text{n}} {\text{= x}}_{\text{n}} {\text{- x}}_{\text{n-k}} {\text{+ a}}_{\text{n-k}} {\text{. u}}_{\text{n-k}}$
where xₙ denotes an input signal; yₙ denotes an output signal; uₙ denotes a parameter; each of aₙ and bₙ is a function of uₙ; k is a positive integer; the subscript "n" refers to an n-th sample of a sampled digital signal; and the subscript "n-k" refers to a sample k-sample periods before the n-th sample.

2. An apparatus according to claim 1, wherein said apparatus comprises:
a high-pass filter means (100, 200) for obtaining a high frequency component signal uₙ of an input signal xₙ from the input signal xₙ and a feedback signal aₙ.uₙ;
a first non-linear processing means (7) for multiplying the signal uₙ by a coefficient aₙ which is a function of uₙ to obtain said feedback signal aₙ.uₙ;
a second non-linear processing means (9) for multiplying the signal uₙ by a coefficient bₙ which is a function of uₙ to obtain a signal bₙ.uₙ; and
an operation means (12) for mixing the input signal xₙ and the signal bₙ.uₙ by a predetermined operation to obtain an output signal yₙ.

3. An apparatus according to claim 2, wherein said high-pass filter means (100) comprises:
a first delay means (2) for delaying the input signal xₙ by sampling periods to obtain a delayed input signal xₙ₋ₖ;
a subtraction means (3) for subtracting the delayed input signal xₙ₋ₖ from the input signal xₙ to obtain a signal xₙ-xₙ₋ₖ;
a second delay means (5) for delaying the feedback signal aₙ.uₙ by k sampling periods to obtain a delayed feedback signal aₙ₋ₖ.uₙ₋ₖ; and
an addition means (4) for adding the signal xₙ - xₙ₋ₖ from the subtraction means and the delayed feedback signal aₙ₋ₖ.uₙ₋ₖ to obtain the high frequency component signal uₙ which is expressed as ${\text{u}}_{\text{n}} {\text{= x}}_{\text{n}} {\text{- x}}_{\text{n-k}} {\text{+ a}}_{\text{n-k}} {\text{.u}}_{\text{n-k}}$ .

4. An apparatus according to claim 2, wherein said high-pass filter means (200) comprises;
a subtraction means (21) for subtracting the input signal xₙ from the feedback signal aₙ.uₙ to obtain a signal aₙ.uₙ - xₙ;
a delay means (20) for delaying the signal aₙ.uₙ - xₙ by k sampling periods to obtain a delayed signal aₙ₋ₖ.uₙ₋ₖ - xₙ₋ₖ; and
an addition means (22) for adding the delayed signal aₙ₋ₖ.uₙ₋ₖ - xₙ₋ₖ to the input signal xₙ to obtain the high frequency component signal uₙ which is expressed as ${\text{u}}_{\text{n}} {\text{= x}}_{\text{n}} {\text{- x}}_{\text{n-k}} {\text{+ a}}_{\text{n-k}} {\text{.u}}_{\text{n-k}}$ .

5. A digital non-linear pre-emphasis/de-emphasis apparatus comprising:
a high-pass filter means (100, 200) for obtaining a high frequency component signal of an input signal from the input signal and a feedback signal;
first and second non-linear processing means (7, 8) each for multiplying the high frequency component signal by a coefficient which is a function of the high frequency component signal;
a first switching means (6) for selecting one of output signals of said first and second non-linear processing means to obtain said feedback signal which is fed back to said high-pass filter means to vary a frequency band of said high-pass filter means;
third and fourth non-linear processing means (9, 10) each for multiplying the high frequency component signal by a coefficient which is a function of the high frequency component signal;
a second switching means (11) for selecting one of output signals of said third and fourth non-linear processing means; and
an operation means (12) for mixing the input signal and an output signal of said second switching means by a predetermined operation to obtain an output signal,
wherein said apparatus executes a non-linear pre-emphasis process when said first and second switching means respectively select said first and third non-linear processing means, and a non-linear de-emphasis process when said first and second switching means respectively select said second and fourth non-linear processing means.

6. An apparatus according to claim 5, wherein, supposing that output signals of said first and third non-linear processing means (7, 9) are respectively a(u). u and b(u).u with respect to an input signal thereto u, where each of a(u) and b(u) is a function of u, and that output signals of said second and fouth non-linear processing means (8, 10) are respectively A(U).U and B(U).U with respect to an input signal thereto U, where each of A(U) and B(U) is a function of U, said apparatus satisfies the following conditions: 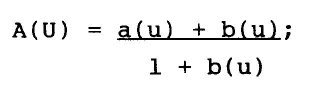 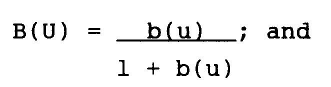 $\text{U = (1 + b(u)).u}$
whereby said non-linear de-emphasis process has a reverse characteristic to that of said non-linear pre-emphasis process.

7. An apparatus according to claim 5, wherein said high-pass filter means (100) comprises;
a first delay means (2) for delaying the input signal by a predetermined time to obtain a delayed input signal;
a subtraction means (3) for subtracting the delayed input signal from the input signal;
a second delay means (5) for delaying the feedback signal by the predetermined time to obtain a delayed feedback signal; and
an addition means (4) for adding an output signal of said subtraction means and the delayed feedback signal to obtain the high frequency component signal.

8. An apparatus according to claim 5, wherein said high-pass filter means (200) comprises:
a subtraction means (21) for subtracting the feedback signal from the input signal;
a delay means (20) for delaying an output signal of said subtraction means by a predetermined time; and
an addition means (22) for adding an output signal of said delay means and the input signal to obtain the high frequency component signal.

## Patentansprüche

1. Vorrichtung zur digitalen nichtlinearen Vorverzerrung und Nachentzerrung gekennzeichnet durch Erfüllen der folgenden Bedingungen:
${\text{y}}_{\text{n}} {\text{= b}}_{\text{n}} {\text{· u}}_{\text{n}} {\text{+ x}}_{\text{n}}$ ; und
${\text{u}}_{\text{n}} {\text{= x}}_{\text{n}} {\text{- x}}_{\text{n-k}} {\text{+ a}}_{\text{n-k}} {\text{· u}}_{\text{n-k}}$
worin xₙ ein Eingangssignal, yₙ ein Ausgangssignal und uₙ einen Parameter bezeichnet; aₙ und bₙ Funktionen von uₙ sind; k eine positive Ganzzahl ist; der Index "n" eine n-te Abtastung eines abgetasteten Digitalsignals betrifft, und der Index "n-k" eine Abtastung k Abtastperioden vor der n-ten Abtastung betrifft.

2. Vorrichtung nach Anspruch 1, worin die Vorrichtung umfaßt:
eine Hochpaßfiltereinrichtung (100, 200), um einen hochfrequenten Signalanteil uₙ eines Eingangssignals xₙ von dem Eingangssignal xₙ und ein Rückkopplungssigal aₙ · uₙ zu gewinnen;
eine erste nichtlineare Verarbeitungseinrichtung (7), um das Signal uₙ mit einem Koeffizienten aₙ zu multiplizieren, der eine Funktion von uₙ ist, um ein Rückkopplungssignal aₙ · uₙ zu gewinnen;
eine zweite nichtlineare Verarbeitungseinrichtung (9), um das Signal uₙ mit einem Koeffizienten bₙ zu multiplizieren, der eine Funktion von uₙ ist, um ein Signal bₙ · uₙ zu gewinnen, und
eine Operationseinrichtung, um das Eingangssignal xₙ und das Signal bₙ · uₙ durch eine vorbestimmte Operation zu mischen, um ein Ausgangssignal yₙ zu gewinnen.

3. Vorrichtung nach Anspruch 2, worin die Hochpaßfiltereinrichtung (100) umfaßt:
eine erste Verzögerungsseinrichtung (2), um das Eingangssignal xₙ um Abtastperioden zu verzögern, um ein verzögertes Eingangssignal xₙ₋ₖ zu gewinnen;
eine Subtraktionseinrichtung (3), um das verzögerte Eingangssignal xₙ₋ₖ von dem Eingangssignal xₙ zu subtrahieren, um ein Signal xₙ - xₙ₋ₖ zu gewinnen;
eine zweite Verzögerungseinrichtung (5), um das Rückkopplungssignal aₙ · uₙ um k Abtastperioden zu verzögern, um ein verzögertes Rückkopplungssignal aₙ₋ₖ · uₙ₋ₖ zu gewinnen, und
eine Additionseinrichtung (4), um das Signal xₙ - xₙ₋ₖ von der Subtraktionseinrichtung und das verzögerte Rückkopplungssignal aₙ₋ₖ · uₙ₋ₖ zu addieren, um den hochfrequenten Signalanteil uₙ zu gewinnen, der als ${\text{u}}_{\text{n}} {\text{= x}}_{\text{n}} {\text{- x}}_{\text{n-k}} {\text{+ a}}_{\text{n-k}} {\text{· u}}_{\text{n-k}}$ ausgedrückt wird.

4. Vorrichtung nach Anspruch 2, worin die Hochpaßfiltereinrichtung (200) umfaßt:
eine Subtraktionseinrichtung (21), um das Eingangssignal xₙ von dem Rückkopplungssignal aₙ · uₙ zu subtrahieren, um ein Signal aₙ · uₙ -xₙ zu gewinnen;
eine Verzögerungseinrichtung (20), um das Signal aₙ · uₙ - xₙ um k Abtastperioden zu verzögern, um ein verzögertes Signal aₙ₋ₖ · uₙ₋ₖ -xₙ₋ₖ zu gewinnen, und
eine Additionseinrichtung (22), um das verzögerte Signal aₙ₋ₖ · uₙ₋ₖ -xₙ₋ₖ zu dem Eingangssignal xₙ zu addieren, um den hochfrequenten Signalanteil uₙ, der als ${\text{u}}_{\text{n}} {\text{= x}}_{\text{n}} {\text{- x}}_{\text{n-k}} {\text{+ a}}_{\text{n-k}} {\text{· u}}_{\text{n-k}}$ ausgedrückt wird, zu gewinnen.

5. Vorrichtung zur digitalen nichtlinearen Vorverzerrung und Nachentzerrung, umfassend:
eine Hochpaßfiltereinrichtung (100, 200), um einen hochfrequenten Signalanteil eines Eingangssignals von dem Eingangssignal und ein Rückkopplungssignal zu gewinnen;
eine erste und zweite nichtlineare Verarbeitungseinrichtung (7, 8), jede zum Multiplizieren des hochfrequenten Signalanteils mit einem Koeffizienten, der eine Funktion des hochfrequenten Signalanteils ist;
eine erste Schalteinrichtung (6) zum Auswählen eines der Ausgangssignale der ersten und zweiten nichtlinearen Verarbeitungseinrichtung, um das Rückkopplungssignal zu gewinnen, das zu der Hochpaßfiltereinrichtung zurückgeführt wird, um ein Frequenzband der Hochpaßfiltereinrichtung zu verändern;
ein dritte und vierte nichtlineare Verarbeitungseinrichtung (9, 10), jede zum Multiplizieren des hochfrequenten Signalanteils mit einem Koeffizienten, der eine Funktion des hochfrequenten Signalanteils ist;
eine zweite Schalteinrichtung (11) zum Auswählen eines der Ausgangssignale der dritten und vierten nichtlinearen Verarbeitungseinrichtung, und
eine Operationseinrichtung (12) um das Eingangssignal und ein Ausgangssignal von der zweiten Schalteinrichtung durch eine vorbestimmte Operation zu mischen, um ein Ausgangssignal zu gewinnen,
worin die Vorrichtung einen nichtlinearen Vorverzerrungsprozeß ausführt, wenn die erste und zweite Schalteinrichtung die erste bzw. dritte nichtlineare Verarbeitungseinrichtung auswählen, und einen nichtlinearen Nachentzerrungsprozeß ausführt, wenn die erste und zweite Schalteinrichtung die zweite bzw. vierte nichtlineare Verarbeitungseinrichtung auswählen.

6. Vorrichtung nach Anspruch 5, worin unter der Voraussetzung, daß die Ausgangssignale der ersten und dritten nichtlinearen Verarbeitungseinrichtung (7, 9) in bezug auf ihr Eingangssignal u a(u)·u bzw. b(u)·u sind, wo a(u) und b(u) jeweils Funktionen von u sind, und daß die Ausgangssignale der zweiten und vierten nichtlinearen Verarbeitungseinrichtung (8, 10) in bezug auf ihr Eingangssignal U A(U)·U bzw. B(U)·U sind, wo A(U) und B(U) jeweils Funktionen von U sind, die Vorrichtung die folgenden Bedingungen erfüllt: 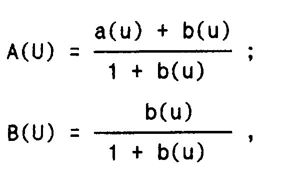 und
$\text{U = (1 + b(u))·u}$
wobei der nichtlineare Nachentzerrungsprozeß eine dem nichtlinearen Vorverzerrungsprozeß entgegengesetzte Charakteristik besitzt.

7. Vorrichtung nach Anspruch 5, worin die Hochpaßfiltereinrichtung (100) umfaßt:
eine erste Verzögerungsseinrichtung (2), um das Eingangssignal um eine vorbestimmte Zeit zu verzögern, um ein verzögertes Eingangssignal zu gewinnen;
eine Subtraktionseinrichtung (3), um das verzögerte Eingangssignal von dem Eingangssignal zu subtrahieren;
eine zweite Verzögerungseinrichtung (5), um das Rückkopplungssignal um die vorbestimmte Zeit zu verzögern, um ein verzögertes Rückkopplungssignal zu gewinnen, und
eine Additionseinrichtung (4), um ein Ausgangssignal der Subtraktionseinrichtung und das verzögerte Rückkopplungssignal zu addieren, um den hochfrequenten Signalanteil zu gewinnen.

8. Vorrichtung nach Anspruch 5, worin die Hochpaßfiltereinrichtung (200) umfaßt:
eine Subtraktionseinrichtung (21), um das Rückkopplungssignal von dem Eingangssignal zu subtrahieren;
eine Verzögerungseinrichtung (20), um ein Ausgangssignal der Subtraktionseinrichtung um eine vorbestimmte Zeit zu verzögern, und
eine Additionseinrichtung (22), um ein Ausgangssignal der Verzögerungseinrichtung und das Eingangssignal zu addieren, um den hochfrequenten Signalanteil zu gewinnen.

## Revendications

1. Appareil de préaccentuation- désaccentuation non linéaire numérique, caractérisé en ce qu'il satisfait les conditions suivantes :
${\text{y}}_{\text{n}} {\text{= b}}_{\text{n}} {\text{.u}}_{\text{n}} {\text{+ x}}_{\text{n}}$
${\text{u}}_{\text{n}} {\text{= x}}_{\text{n}} {\text{- x}}_{\text{n-k}} {\text{+ a}}_{\text{n-k}} {\text{.u}}_{\text{n-k}}$
où xₙ indique un signal d'entrée ; yₙ indique un signal de sortie ; uₙ indique un paramètre ; aₙ et bₙ sont chacune une fonction de uₙ ; k est un entier positif ; l'indice "n" indique le énième échantillon d'un signal numérique échantillonné ; et l'indice "n-k" indique un échantillon situé à k périodes d'échantillonnage avant le énième échantillon.

2. Appareil selon la revendication 1 dans lequel ledit appareil comporte :
des moyens de filtrage passe haut (100 , 200) pour obtenir un signal uₙ de composantes haute fréquence dans un signal d'entrée xₙ à partir du signal d'entrée xₙ et un signal de rétroaction aₙ.uₙ ;
des premiers moyens (7) de traitement non linéaire pour multiplier le signal uₙ par un coefficient aₙ qui est une fonction de uₙ pour obtenir ledit signal de rétroaction aₙ.uₙ ;
des seconds moyens de traitement (9) non linéaire pour multiplier le signal uₙ par un coefficient bₙ, qui est une fonction de uₙ pour obtenir un signal bₙ.uₙ ; et
des moyens d'opération (12) pour mélanger le signal d'entrée xₙ et le signal bₙ.uₙ par une opération prédéterminée pour obtenir un signal de sortie yₙ.

3. Appareil selon la revendication 2 dans lequel lesdits moyens de filtrage passe haut (100) comportent :
des premiers moyens à retard (2) pour retarder le signal d'entrée xₙ d'un nombre prédéterminé de périodes d'échantillonnage pour obtenir un signal d'entrée retardé xₙ₋ₖ ;
des moyens de soustraction (3) pour soustraire le signal d'entrée retardé xₙ₋ₖ du signal d'entrée xn pour obtenir un signal xₙ - xₙ₋ₖ ;
des seconds moyens à retard (5) pour retarder le signal de rétroaction aₙ.uₙ de k périodes d'échantillonnage pour obtenir un signal de rétroaction retardée aₙ₋ₖ.uₙ₋ₖ ; et
des moyens d'addition (4) pour ajouter le signal xₙ - xₙ₋ₖ provenant du circuit de soustraction et le signal de rétroaction retardé aₙ₋ₖ.uₙ₋ₖ pour obtenir le signal uₙ de composantes haute fréquence qui est exprimé par :
${\text{u}}_{\text{n}} {\text{= x}}_{\text{n}} {\text{- x}}_{\text{n-k}} {\text{+ a}}_{\text{n-k}} {\text{.u}}_{\text{n-k}}$

4. Appareil selon la revendication 2 dans lequel lesdits moyens de filtrage passe haut (200) comportent :
des moyens de soustraction (21) pour soustraire le signal d'entrée xₙ du signal de rétroaction aₙ.Uₙ pour obtenir un signal aₙ.Uₙ - xₙ ;
des moyens à retard (20) pour retarder le signal aₙ.uₙ - xₙ de k périodes d'échantillonnage pour obtenir un signal retardé aₙ₋ₖ. uₙ₋ₖ - xₙ₋ₖ ; et
des moyens d'addition (22) pour ajouter le signal retardé aₙ₋ₖ. uₙ₋ₖ - xₙ₋ₖ au signal d'entrée xₙ pour obtenir le signal uₙ de composantes haute fréquence qui est exprimé par ${\text{u}}_{\text{n}} {\text{= x}}_{\text{n}} {\text{- x}}_{\text{n-k}} {\text{+ a}}_{\text{n-k}} {\text{. u}}_{\text{n-k}}$ .

5. Appareil de préaccentuation- désaccentuation non linéaire numérique comprenant :
des moyens de filtrage passe haut (100, 200) pour obtenir un signal de composantes haute fréquence d'un signal d'entrée à l'aide du signal d'entrée et d'un signal de rétroaction ;
des premiers et seconds moyens de traitement non linéaire (7, 8) dont chacun multiplie le signal de composantes haute fréquence par un coefficient qui est une fonction du signal de composantes haute fréquence ;
des premiers moyens de commutation (6) pour sélectionner l'un des signaux de sortie desdits premiers et seconds moyens de traitement non linéaire pour obtenir ledit signal de rétroaction qui est retourné auxdits moyens de filtrage passe haut pour faire varier la bande de fréquence desdits moyens de filtrage passe haut ;
des troisièmes et quatrièmes moyens de traitement non linéaire (9, 10) dont chacun multiplie le signal de composantes haute fréquence par un coefficient qui est une fonction du signal de composantes haute fréquence ;
des seconds moyens de commutation (11) pour sélectionner l'un des signaux de sortie desdits troisièmes et quatrièmes moyens de traitement non linéaire ; et
des moyens d'opération (12) pour mélanger le signal d'entrée et un signal de sortie desdits seconds moyens de commutation par une opération prédéterminée pour obtenir un signal de sortie ;
dans lequel ledit appareil exécute un traitement de préaccentuation non linéaire quand lesdits premiers et seconds moyens de commutation (11) sélectionnent respectivement lesdits premiers et troisièmes moyens de traitement non linéaire, et un traitement de désaccentuation non linéaire quand lesdits premiers et seconds moyens de commutation sélectionnent respectivement lesdits seconds et quatrièmes moyens de traitement non linéaire.

6. Appareil selon la revendication 5, dans lequel, en supposant que les signaux de sortie desdits premiers et troisièmes moyens de traitement non linéaire (7, 9) sont respectivement a(u).u et b(u).u relativement à un signal d'entrée qui soit u, dans lequel chacun des a(u) et b(u) est une fonction de u, et en supposant que les signaux de sortie desdits seconds et quatrièmes moyens de traitement non linéaire (8, 10) sont respectivement A(U).U et B(U).U relativement à un signal d'entrée qui soit U, dans lequel chacun des A(U) et B(U) est une fonction de U, ledit appareil satisfait les équations suivantes : 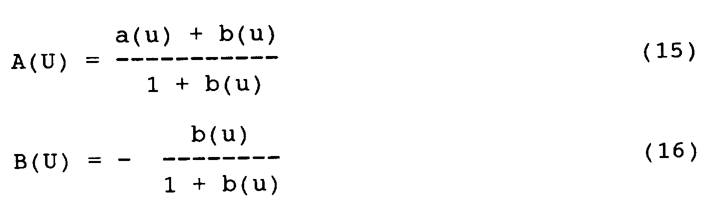 $\text{U = (1 + b(u)) . u (17)}$
dans lequel ledit traitement de désaccentuation non linéaire présente une caractéristique inverse de celle dudit traitement de préaccentuation non linéaire.

7. Appareil selon la revendication 5, dans lequel lesdits moyens de filtrage passe haut (100) comportent :
des premiers moyens à retard (2) pour retarder le signal d'entrée d'une durée prédéterminée pour obtenir un signal d'entrée retardé ;
un moyen de soustraction (3) pour soustraire le signal d'entrée retardé du signal d'entrée ;
un second moyen à retard (5) pour retarder le signal de rétroaction de la durée prédéterminée pour obtenir le signal de rétroaction retardé ; et
un moyen d'addition (4) pour ajouter un signal de sortie dudit moyen de soustraction et le signal de rétroaction retardé pour obtenir le signal de composantes haute fréquence.

8. Appareil selon la revendication 5, dans lequel lesdits moyens de filtrage passe haut (200) comportent :
un moyen de soustraction (21) pour soustraire le signal de rétroaction du signal d'entrée ;
un moyen à retard (20) pour retarder un signal de sortie dudit moyen de soustraction d'un durée prédéterminée ; et
un moyen d'addition (22) pour ajouter un signal de sortie dudit moyen à retard et le signal d'entrée pour obtenir le signal de composantes haute fréquence.
